# EUROPÄISCHE PATENTSCHRIFT

(11) **EP 1 257 882 B1**
(45) Veröffentlichungstag und Bekanntmachung des Hinweises auf die Patenterteilung: **11.04.2007**
(21) Anmeldenummer: 01913762.9
(22) Anmeldetag: 23.01.2001
(51) Int. Cl.: G03F 7/20, G01J 9/02

(54) **VORRICHTUNG ZUR WELLENFRONTERFASSUNG**
DEVICE FOR DETECTING WAVE FRONTS
DISPOSITIF POUR MESURER UN FRONT D'ONDE

(30) Priorität: 23.02.2000 DE 10008181
(43) Veröffentlichungstag der Anmeldung: 20.11.2002
(73) Patentinhaber: Carl Zeiss SMT AG, 73447 Oberkochen (DE)
(72) Erfinder: WEGMANN, Ulrich, 89551 Königsbronn (DE); FREISCHLAD, Klaus, Tucson, Arizona 85719-5642 (US)
(74) Vertreter: Muschik, Thomas
(86) Internationale Anmeldenummer: PCT/EP2001/000704
(87) Internationale Veröffentlichungsnummer: WO 2001/063233

(56) Entgegenhaltungen:
- DE-A- 19 826 409
- US-A- 4 399 356
- US-A- 4 413 909
- US-A- 4 518 854
- US-A- 5 357 311
- US-A- 5 715 039
- US-A- 5 835 217
- US-A- 5 978 085

## Beschreibung

Die Erfindung betrifft eine Vorrichtung zur Erfassung von Wellenfronten elektromagnetischer Strahlung, insbesondere sichtbaren und ultravioletten Lichts und weicher Röntgenstrahlung, nach dem Oberbegriff von Anspruch 1.

Eine gattungsgemässe Vorrichtung zur Wellenfronterfassung ist aus "Phase measuring Ronchi test" von Katsuyuki Omura et al. (Seiten 523-528 in APPLIED OPTICS/Vol. 27, No. 3/ Februar 1988) bekannt. Bei dieser bekannten Vorrichtung, welche zur Prüfung der Abbildungsqualität einer Testlinse verwendet wird, erzeugt eine monochromatische Punktlichtquelle eines He-Ne-Lasers eine Wellenfront, welche einen Kollimator und eine Testlinse durchsetzt und danach auf ein als Ronchi-Gitter bezeichnetes Beugungsgitter auftrifft. Der Kollimator formt die von der Punktlichtquelle ausgehende Wellenfront in eine auf die Testlinse auftreffende Planwelle um, wobei das Beugungsgitter in der bildseitigen Fokusebene der Testlinse liegt. Das vom Ronchi-Gitter erzeugte Beugungsmuster bzw. Interferogramm wird von einem eine TV-Kamera umfassenden ortsauflösenden Detektor aufgenommen und darauf zur Erfassung der das optische System verlassenden Wellenfront ausgewertet.

Auch die DD 0154 239 offenbart eine als Shearing-Interferometer bezeichnete gattungsgemässe Vorrichtung zur Wellenfronterfassung für die interferometrische Prüfung von Objektiven. Bei dieser Vorrichtung zur Wellenfronterfassung liegt das Beugungsgitter ausserhalb der Fokusebene des Prüflingsobjektivs.

In der DE 195 38 747 A1 ist ein gattungsgemässes Gittershearinterferometer zur Wellenfronterfassung beschrieben, bei der das Licht einer zu untersuchenden Planwelle auf zwei hintereinandergeschaltete Phasengitter fällt und zur Wellenfrontanalyse dann von einer CCD-Kamera erfasst wird.

Aus dem Aufsatz "Evaluation of Large Aberrations Using a Lateral-Shear Interferometer Having Variable Shear" von M. P. Rimmer et al. in APPLIED OPTICS/Vol. 14, No. 1/ Januar 1975/Seiten 142-150 ist eine weitere Vorrichtung zur Wellenfronterfassung nach dem Oberbegriff von Anspruch 1 bekannt. Das zwischen Wellenfrontquelle und Beugungsgitter geschaltete optische System ist in diesem Fall ein gekrümmter Spiegel.

J. E. Pearson et al. haben in APPLIED OPTICS AND OPTICAL ENGINEERING, Vol. VII, Academic Press. Inc., 1979, Kapitel 8 "Adaptive Optical Techniques for Wave-Front Correction" auf adaptive Optiken mit Scherinterferometern als Wellenfrontsensoren und auf die Photolithografie als mögliches Anwendungsfeld dafür hingewiesen.

Der Aufsatz "Dynamic range of Ronchi test with a phase-shifted sinusoidal grating" von K. Hibino et al. in APPLIED OPTICS/Vol. 36, No. 25/September 1997/Seiten 6178-6189 beschreibt eine gattungsgemässe Vorrichtung zur Wellenfronterfassung, bei der eine Testlinse eine monochromatische ebene Welle umformt und auf ein als Sinus-Transmissionsgitter ausgebildetes Beugungsgitter lenkt. Die von dem Beugungsgitter gebeugten Wellenfronten werden von einer Abbildungslinse kollimiert und bilden auf einer in der Fokusebene der Abbildungslinse angeordneten, rotierenden Mattscheibe ein Scherinterferogramm, welches von einem CCD-Detektor erfasst und dann zur Prüfung der Testlinse ausgewertet wird.

Das Patent US 4,413,909 zeigt eine Vorrichtung zur Wellenfrontvermessung mit einer Hartman-Maske. Eine Lichtquelle befindet sich in der objektseitigen Brennebene eines Testobjekts. Das Testobjekt kollimiert das Licht und formt eine im Wesentlichen ebene Welle, deren Aberrationen bestimmt werden sollen. Hinter dem Testobjekt befindet sich eine mit einer Vielzahl von Öffnungen versehene Hartman-Maske, die die ebene Welle in eine Anzahl von Subaperturen aufteilt. Das von der Hartman-Maske kommende Licht wird von einer Linse kollimiert und fällt auf ein Beugungsgitter. Das aus dem Beugungsgitter austretende Licht wird kollimiert und mit Hilfe eines Detektors analysiert.

Das Patent US 4, 518,854 beschreibt eine Vorrichtung zur Wellenfrontvermessung, welche bestimmte Eigenschaften von Vorrichtungen des Hartman-Typs und des Schearing-Interferometers kombiniert. Sämtliche optischen Komponenten der Vorrichtung sind in Strahlrichtung hinter dem zu vermessenden optischen System angeordnet und verarbeiten die von dem optischen System deformierte Wellenfront.

Aufgabe der Erfindung ist es, eine verbesserte gattungsgemässe Vorrichtung zur Wellenfronterfassung bereitzustellen.

Diese Aufgabe wird durch die Merkmale in Anspruch 1 gelöst. Denn durch die zweidimensionale Struktur der Wellenfrontquelle kann die räumliche Kohärenz der in das zu vermessende optische System eintretenden Strahlung so angepasst werden, dass die von dem optischen System umgeformten Wellenfronten hochgenau gemessen werden können.

Erfindungsgemäß kann dies mit der Betriebslichtquelle bei der Betriebswellenlänge des optischen Systems erfolgen. Die Vorrichtung zur Wellenfronterfassung nach der Erfindung ist sowohl für kohärente als auch für inkohärente Strahlung vom Infrarot- bis in den Röntgenbereich geeignet. Bereits bei Verwendung konventioneller CCD-Kameratechnik für den ortsauflösenden Detektor ist ein großer Spektralbereich zugänglich. Bei extrem kurzen Wellenlängen kann z. B. aber auch ein Photoemissions-Elektronenmikroskop (PEEM) als ortsauflösender Detektor eingesetzt werden.

Abweichend vom zitierten Stand der Technik ist es erfindungsgemäß auch nicht erforderlich, das zu testende optische System, z.B. durch Vorschaltung eines Kollimators, mit einer Planwelle zu bestrahlen.

Für sehr kurze Wellenlängen bis in den Röntgenbereich hinein kann es dabei günstig sein, die Wellenfrontquelle als reflektierendes Element, z. B. als Reflexionsmaske, auszubilden.

Bei einer vorteilhaften Ausführungsform umfaßt die Wellenfrontquelle eine Lochmaske, wodurch die zweidimensionale Struktur der Wellenfrontquelle hohen Kontrast aufweist. Eine derartige Lochmaske kann insbesondere eine Mehrzahl in vierzähliger oder dreizähliger Symmetrie angeordneter Öffnungen aufweisen.

Dabei kann die Lochmaske zwischen einer Austrittsfläche eines Lichtleiters und dem optischen System angeordnet sein. Insbesondere dann, wenn die Lochmaske mit dem Lichtleiter verbunden ist, erhält man eine kompakte Wellenfrontquelle hoher Leuchtdichte.

Wenn die Lochmaske in einer Objektebene und das Beugungsgitter in einer zur Objektebene konjugierten Bildebene liegt, kann die Wellenfront bei der Endlich-Endlich-Abbildung des optischen Systems unter Einhaltung der exakten Schnittweite des optischen Systems gemessen werden. Damit kann die Qualität eines optischen Systems in seinem spezifischen Einsatzbereich geprüft werden. Da dies ohne Einbringung zusätzlicher Bauteile, z.B. von Kollimatorlinsen, in den Strahlengang des optischen Systems zwischen Objekt und Bild möglich ist, kann durch die Erfindung auf die Kalibrierung derartiger zusätzlicher Bauteile verzichtet werden.

Bei einer weiteren vorteilhaften Ausführungsform ist einer Lichtleiter-Lochmasken-Kombination ein Verschiebungsmodul zugeordnet, welches die Lochmaske zusammen mit der Austrittsfläche des Lichtleiters in der Objektebene verschiebt. Durch die derart mögliche Verschiebung der Wellenfrontquelle kann die Abbildungsqualität des optischen Systems für ein großes Abbildungsfeld gemessen werden.

Der Lichtleiter kann ein Multimode-Lichtleiter sein, um die Abbildungsqualität des optischen Systems auch bei Verwendung von Weißlicht, d.h. eines Wellenlängengemischs, oder von Multimode-Lasem kurzer Kohärenzlänge (einige 10 µm) prüfen zu können. Selbstverständlich ist unter Lichtleiter ein über den sichtbaren Spektralbereich der elektromagnetischen Strahlung hinaus geeigneter Strahlungsleiter gemeint.

Bei einer weiteren vorteilhaften Ausführungsform ist das Beugungsgitter in Abhängigkeit von der Struktur der Wellenfrontquelle derart ausgebildet, daß zur Interferenz am Beugungsgitter nur bestimmte Beugungsordnungen beitragen.

Unabhängig davon kann das Beugungsgitter ein Phasengitter oder ein Amplitudengitter oder von jedem anderen geeigneten Beugungsgittertyp sein, z. B. ein durch Dithering erzeugtes Grauwertgitter oder auch ein reflektierendes Gitter, welches sich insbesondere für sehr kurze Wellenlängen anbietet.

Einer anderen Ausführungsform gemäß weist das Beugungsgitter jeweils eine beugende periodische Struktur für unterschiedliche Richtungen auf. Dadurch können aus einem einzigen, von dem ortsauflösenden Detektor aufgenommenen Interferogramm Phasengradienten in mehr als einer Richtung bestimmt werden.

Dabei ist es besonders vorteilhaft, wenn diese Richtungen orthogonal zueinander sind, wie z.B. bei einem als Schachbrettgitter oder Kreuzgitter ausgebildeten Beugungsgitter. Denn dadurch wird die im Sinne der Theorie des lateralen Shearinginterferometers durch das Beugungsgitter verursachte Scherung simultan in X- und Y-Richtung erzeugt.

Es kann das Beugungsgitter aber auch Winkel von z. B. 45°, 60° oder 120° einschließende Periodizitätsrichtungen aufweisen. Bei einem als Dreiecksgitter mit jeweils paarweise einen Winkel von 120° einschließenden Periodizitätsrichtungen ausgebildeten Beugungsgitter oder einem Dreiecksgitter mit 45° und 90°, d. h. mit gleichschenkligen und rechtwinkligen Dreiecken ergeben sich mehr als zwei Periodizitäts- bzw. Verschiebungsrichtungen. Die daraus resultierende Redundanz kann durch Ausgleichsrechnung zur Erhöhung der Meßgenauigkeit genutzt werden.

Derartige Beugungsgitter mit mehreren Periodizitätsrichtungen, z. B. in X- und Y-Richtung periodische Sinusgitter, können im Hinblick auf die Unterdrückung unerwünschter Beugungsordnungen und auf ihre Herstellung geeigneterweise auch als Phasengitter ausgeführt werden.

Um ein optisches System bei seiner Betriebsschnittweite möglichst genau prüfen zu können, ist es wünschenswert, das Beugungsgitter so genau als möglich in der zur Objektebene konjugierten Bildebene einzujustieren. Dazu umfaßt das Beugungsgitter ein in unterschiedlichen Periodizitätsrichtungen jeweils eine beugende periodische Struktur aufweisendes Gitter und ein zu diesem koplanares Liniengitter, z. B. ein in der Ebene des Beugungsgitters angeordnetes, mit dem Beugungsgitter verbundenes Liniengitter. Denn in Kombination mit einem weiteren Liniengitter in der Objektebene, welches in seiner Gitterkonstante auf den Abbildungsmaßstab des optischen Systems und die Gitterkonstante des mit dem Beugungsgitter verbundenen Liniengitters angepaßt ist, entsteht bei geeigneter Orientierung der beiden Liniengitter ein Moirémuster. Die beste Einstellebene für das Beugungsgitter ist dann durch den maximalen Moirékontrast gekennzeichnet.

Im Hinblick auf die Auswertung des Interferogramms ist es günstig, wenn dem Beugungsgitter ein Translationsmodul zur Verschiebung des Beugungsgitters in den zueinander orthogonalen Richtungen zugeordnet ist. Damit kann durch eine Bewegung des Beugungsgitters um ganzzahlige Vielfache der jeweiligen Gitterperiode der Kontrast eines der orthogonalen Interferenzsysteme unterdrückt werden.

Das Beugungsgitter kann aber auch ein Liniengitter sein, wobei dem Beugungsgitter dann vorteilhafterweise ein Rotationsmodul zur Drehung des Beugungsgitters um 90° zugeordnet ist, um zur vollständigen Wellenfrontrekonstruktion beide orthogonalen Interferenzsysteme erfassen zu können.

Durch ein zwischen dem Beugungsgitter und dem Detektor angeordnetes Abbildungssystem kann der Detektor in geeigneter Weise auf das Interferogramm angepaßt werden. Dabei ist es vorteilhaft, wenn das dem Lichtleiter zugeordnete Verschiebungsmodul bei einer Verschiebung der Austrittsfläche des Lichtleiters auch das Abbildungssystem parallel zur Bildebene verschiebt.

Bei Korrektur eines derartigen Abbildungssystems auf die Abbesche Sinusbedingung wird die durch das Beugungsgitter verursachte laterale Scherung der Wellenfronten für alle Öffnungswinkel konstant auf den Detektor übertragen.

Mit einem zwischen einer Strahlungsquelle und der Wellenfrontquelle angeordneten ersten Strahlteiler zum Auskoppeln eines Anteils der die Wellenfrontquelle versorgenden Strahlung und einem zweiten Strahlteiler, der den vom ersten Strahlteiler ausgekoppelten Strahlungsanteil unter Umgehung von optischem System und Beugungsgitter zum Detektor lenkt, kann die Konstanz der Strahlungsquelle bzw. Wellenfrontquelle überwacht werden. Dabei kann ein Referenzlichtleiter den vom ersten Strahlteiler ausgekoppelten Strahlungsanteil zum zweiten Strahlteiler transportieren. Es kann aber auch ein Teil der Beleuchtungsstrahlung am Beugungsgitter vorbei, z. B. durch eine Ausnehmung des Beugungsgitters auf den Detektor gelenkt werden.

Ein zum Beugungsgitter hin gekrümmter Detektor kann das vom Beugungsgitter erzeugte Interferogramm in einer für die nachfolgende Auswertung des Interferogramms vorteilhaften Weise erfassen.

So kann bei einem bereichsweise sphärischen Detektor die durch das Beugungsgitter erzeugte laterale Scherung der Wellenfronten unabhängig vom Beugungswinkel konstant bzw. unverzerrt auf den Detektor übertragen werden. Dies bedingt eine erheblich vereinfachte Rekonstruktion der Wellenfronttopographie aus den Scherinterferogrammen.

Dies wird dadurch verständlich, daß das Scherinterferogramm auf dem Phasenversatz zwischen den gebeugten Wellenfronten und den ungebeugten Wellenfronten beruht und dieser Phasenversatz auf einer zum Ursprung der ungebeugten Wellenfront konzentrischen Kugelfläche konstant ist.

Wenn der Detektor eine zwischen dem Beugungsgitter und der strahlungssensitiven Sensorfläche angeordnete, zumindest bereichsweise sphärische Sekundärstrahlerfläche umfaßt, können für eine erfindungsgemäße Vorrichtung gebräuchliche Bildsensoren mit planer strahlungssensitiver Sensorfläche, z. B. TV-Kameras, CCD-Sensoren, PEEM usw., verwendet werden. Geeignete Sekundärstrahlerflächen können z. B. als Mattscheibe oder als Fluoreszenzschicht ausgebildet sein.

Durch eine geeignete frequenzwandelnde Sekundärstrahlerfläche, z. B. eine Fluoreszenzschicht, kann der Detektor selbst bei Verwendung herkömmlicher, für den sichtbaren Wellenlängenbereich optimierter strahlungssensitiver Sensorflächen innerhalb eines großen Wellenlängenbereichs an die jeweiligen Meßwellenlängen angepaßt werden.

Bei einem weiteren Beispiel umfaßt der Detektor beugungsgitterseitig eine Mehrzahl von Lichtleitern, deren beugungsgitterseitigen Lichtleiterenden auf einer Kugelkalotte angeordnet sind. Dies kann z. B. durch Polieren einer konkaven sphärischen Fläche in das Ende eines bildgebenden Lichtleiterfaserbündels oder in eine Lichtleiterfaserplatte realisiert werden.

Die zwischen dem Beugungsgitter und dem Detektor angeordnete Mehrzahl von Lichtleitern kann als bilderhaltendes Lichtleiterbündel das Interferogramm zu einer relativ frei positionierbaren Sensorfläche transportieren. Dadurch kann z. B. das Beugungsgitter innerhalb und ein als Wärmequelle wirkender Bildsensor, z. B. eine TV-Kamera, außerhalb eines Vakuums angeordnet werden.

Im Hinblick auf eine zuverlässige Erfassung des Scherinterferogramms können die vom Beugungsgitter abgewandten Lichtleiterenden der strahlungssensitiven Sensorfläche direkt zugeordnet sein. Z. B. kann das Faserbündelende direkt auf einen Kamerachip kontaktiert werden.

Der Detektor kann aber auch ein vorzugsweise telezentrisches optisches Abbildungssystem umfassen. Dadurch ist eine auf die Abmessungen der Sensorfläche angepaßte Abbildung des Interferogramms auf die strahlungssensitive Sensorfläche möglich.

Mit einem sowohl das Beugungsgitter als auch eine Sekundärstrahlerfläche aufweisenden Beugungsgitterträger kann die Vorrichtung zur Wellenfronterfassung besonders kompakt sein. Dadurch wird die Integration einer erfindungsgemäßen Vorrichtung zur Wellenfronterfassung in bereits bestehende optische Abbildungseinrichtungen zur betriebsmäßigen Überwachung der Abbildungsqualität möglich.

Besonders vorteilhaft ist eine Halbkugel, welche zwischen dem Beugungsgitter und der strahlungssensitiven Sensorfläche angeordnet ist und das Beugungsgitter auf seinem planen Oberflächenbereich trägt. Denn dadurch können die bereits angeführten Vorteile sphärischer Sensorflächen in einer kompakten und robusten Bauform erzielt werden. Vorzugsweise ist dabei der sphärische Oberflächenbereich der Halbkugel als Sekundärstrahlerfläche ausgebildet.

Diese Halbkugel-Gestaltung des Beugungsgitterträgers kann in herstellungstechnisch effizienter Weise mit einem Lichtleiterfaserbündel und einer Sekundärstrahlerfläche kombiniert werden, wenn die beugungsgitterseitigen Lichtleiterenden durch einen frequenzwandelnden Kitt mit dem sphärischen Oberflächenbereich der Halbkugel verbunden sind.

Bei einer weiteren Ausführungsform ist vor dem Beugungsgitter ein Wellenfrontmodul und zwischen dem Wellenfrontmodul und dem Beugungsgitter ein optisches System angeordnet.

Dadurch kann das optische System mit einer auf das Wellenfrontmodul abgestimmten Beugungsgitter-Detektor-Einheit hochgenau untersucht werden.

Bei einer Mehrzahl von Wellenfrontquellen im Wellenfrontmodul kann das optische System bezüglich seines Objektfelds an einer Mehrzahl von Feldpunkten gleichzeitig, d.h. parallel, untersucht werden. Durch eine derartige gleichzeitige Messung der Wellenfronten an vielen Feldpunkten ist eine erhebliche Verringerung des Zeitaufwands für die Untersuchung eines optischen Systems möglich.

Wenn jede Wellenfrontquelle eine Lochmaske aufweist, kann die Struktur der Wellenfrontquellen derart auf den Abbildungsmaßstab des optischen Systems und das Beugungsgitter abgestimmt sein, daß zur Interferenz am Beugungsgitter nur bestimmte Beugungsordnungen beitragen, wodurch die Auswertung des Interferogramms besonders effizient wird. Ferner gibt eine Lochmaske der zweidimensionalen Struktur der Wellenfrontquelle hohen Kontrast. Im Hinblick auf eine hochgenaue Wellenfrontanalyse kann die Lochmaske eine Mehrzahl von Öffnungen aufweisen.

Bei einem Beispiel ist jeder Wellenfrontquelle eine refraktive oder diffraktive Fokussieroptik zugeordnet, welche einfallendes Beleuchtungslicht zur Wellenfrontquelle hin konzentriert. Dadurch kann die üblicherweise ein relativ großes Objektfeld ausleuchtende Standardbeleuchtungseinrichtung des optischen Systems für das Wellenfrontmodul verwendet werden.

Vorteilhafterweise ist jeder Wellenfrontquelle eine Mehrzahl von Lichtleitern zugeordnet. Dadurch können die Interferogramme der einzelnen Wellenfrontquellen zuverlässig auf einen jeweils zugeordneten Bereich der strahlungssensitiven Sensorfläche abgebildet werden.

Die Zuordnung einer sphärischen Sekundärstrahlerfläche zu jeder Wellenfrontquelle ermöglicht eine unverzerrte Erfassung der durch das Beugungsgitter erzeugten lateralen Scherung durch den Detektor.

Die erfindungsgemäße Vorrichtung ist insbesondere aufgrund ihrer Kompaktheit und Auswerteeffizienz bzw. -genauigkeit zur Prüfung von Projektionsobjektiven für die Mikrolithografie geeignet.

Durch die Verschiebung der Wellenfrontquelle oder des Beugungsgitters in einer seiner Periodizitätsrichtung um ein ganzzahliges Vielfaches der entsprechenden Gitterperiode kann der Kontrast eines der orthogonalen Interferenzsysteme unterdrückt werden und die Auswertung des Interferogramms erheblich vereinfacht werden.

Dabei kann die Verschiebung der Wellenfrontquelle oder des Beugungsgitters während der Bildaufnahmezeit des Detektors, die typischerweise 30 Millisekunden beträgt, erfolgen. Typischerweise ist der Verschiebungsweg des Beugungsgitters dabei 6 bis 18 µm.

Mit einem sehr schnellen Detektor können aber auch während der Verschiebung der Wellenfrontquelle oder des Beugungsgitters eine Mehrzahl von Interferogrammbildern aufgenommen werden, wobei dann zur Wellenfronterfassung die Mehrzahl von Interferogrammbildern verwendet wird. Denn eine Überlagerung der einzelnen Interferogrammbilder entspricht dann wieder der obigen Bildintegration während der kompletten Beugungsgitterverschiebung.

Dieser Verschiebung des Beugungsgitters in einer seiner Periodizitätsrichtung um ein ganzzahliges Vielfaches der entsprechenden Gitterperiode kann die z. B. aus der DE 195 38 747 A1 bekannte Phasenmodulation durch eine Hin- und Herbewegung des Beugungsgitters mit der Frequenz ω und durch anschließendes schmalbandiges Filtern noch überlagert werden.

Im Interferogramm sind dem Nutzsignal erfahrungsgemäß Störsignale überlagert. Diese Störsignale können von Herstellungsfehlern bzw. Imperfektionen des Beugungsgitters oder der Wellenfrontquelle, von selbst kleinsten Dejustagen der Bauteile, von einer nicht perfekten Ausleuchtung der Wellenfrontquelle oder von Geisterbildern bzw. Geisterinterferogrammen aufgrund etwaiger Rückreflexionen aus dem optischem System sowie aus der Vorrichtung zur Wellenfronterfassung (z. B. von der Detektorfläche, Gitterrückseite usw.) herrühren. Diese Störungen sind dem Nutzsignal typischerweise periodisch überlagert, d.h. sie variieren periodisch um den richtigen Meßwert. Ihre Frequenz, Phasenlage und Amplitude können durch Variation der Anfangsphase (Phasenlage des Gitters zur Wellenfrontquelle) erfaßt werden.

Insbesondere bei einer Variation der Phasenlage der Wellenfrontquelle, z. B. durch Verschiebung der Beleuchtungsmaske gegenüber dem ortsfesten Beugungsgitter, zeigen sich dabei deutliche Amplituden, d. h. große Veränderungen der Störsignale.

Da derartige Störungen periodisch um den Mittelwert variieren, können sie durch Verschieben der Position der Wellenfrontquelle oder des Beugungsgitters um definierte Bruchteile der jeweiligen Periode und anschließende Mittelung der Meßwerte rechnerisch eliminiert werden.

Die Anmelderin hat in diesem Zusammenhang herausgefunden, daß die Störsignale einen dominanten Beitrag der zweiten Harmonischen des Nutzsignals aufweisen, also bei der Variation der Anfangsphase um eine Periode des Gitters oder der Wellenfrontquelle zwei Schwingungsperioden durchlaufen.

Die Erfindung betrifft ferner einen Stepper oder Scanner zur Mikrolithografie mit einer der im vorhergehenden beschriebenen Vorrichtung zur Wellenfronterfassung.

Ein derartiger Stepper/Scanner kann ohne größere Störung des Produktionsablaufs in-situ, d.h. am Produktionsstandort und während des Produktionszyklus, auf seine Produktionsqualität, z. B. auf Einhaltung der Toleranzgrenzen der jeweiligen Bildfehler hin überwacht werden, wenn das Wellenfrontmodul betriebsmäßig in die Objektebene des Projektionsobjektivs bringbar und aus ihr entfernbar ist und/oder wenn das Beugungsgitter betriebsmäßig in die Bildebene des Projektionsobjektivs bringbar und aus ihr entfernbar ist.

Besonders günstig ist es dabei, wenn der Stepper/Scanner einen Aberrationsregelkreis aufweist, der über Wirk- oder Manipulatorelemente auf das Projektionsobjektiv einwirken kann.

Eine besondere Eignung der erfindungsgemäßen Vorrichtung zur Wellenfronterfassung in einen Stepper oder Scanner zur Mikrolithografie liegt auch darin begründet, daß sie sowohl für kohärente als auch für inkohärente Strahlung vom Infrarot- bis in den Röntgenbereich geeignet ist, insbesondere auch für Strahlungsquellen kurzer Kohärenzlänge, z. B. eine HBO-Lampe, einen Excimer-Laser oder ein Synchrotronstrahler. Die Produktionsüberwachung kann also mit der Betriebslichtquelle bei der Betriebswellenlänge des Mikrolithografie-Projektionsobjektivs erfolgen.

Im folgenden wird die Erfindung anhand von Ausführungsbeispielen im Zusammenhang mit den beigefügten Figuren erläutert.

Es zeigen in schematischer Darstellung:
- Figur 1: eine Ausführungsform der erfindungsgemäßen Vorrichtung zur Wellenfronterfassung;
- Figur 2: die Beleuchtungsmaske der Wellenfrontquelle von Figur 1 in Draufsicht;
- Figur 3: eine alternative Beleuchtungsmaske in Draufsicht;
- Figur 4: eine weitere, für die Wellenfrontquelle von Figur 1 geeignete Beleuchtungsmaske;
- Figur 5: noch eine weitere, für die Wellenfrontquelle von Figur 1 geeignete Beleuchtungsmaske;
- Figur 6: eine Ausführungsform von Beleuchtungssystem und Beleuchtungsmaske;
- Figur 7: eine weitere Ausführungsform von Beleuchtungssystem und Beleuchtungsmaske;
- Figur 8: das Beugungsgitter der Vorrichtung von Figur 1 in Draufsicht;
- Figur 9: ein zweites, für die Vorrichtung von Figur 1 verwendbares Beugungsgitter;
- Figur 10: ein drittes, für die Vorrichtung von Figur 1 verwendbares Beugungsgitter;
- Figur 11a: ein viertes, für die Vorrichtung von Figur 1 verwendbares Beugungsgitter;

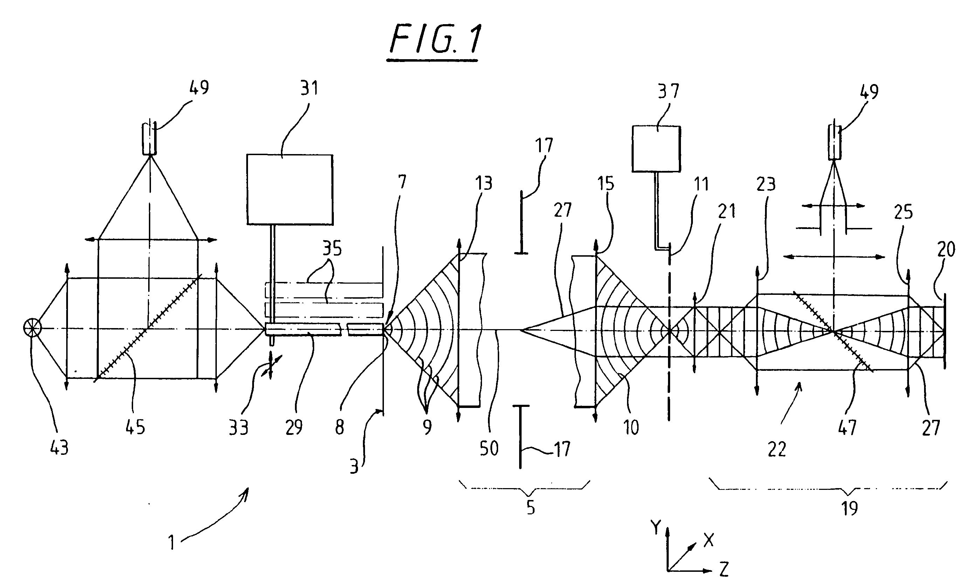

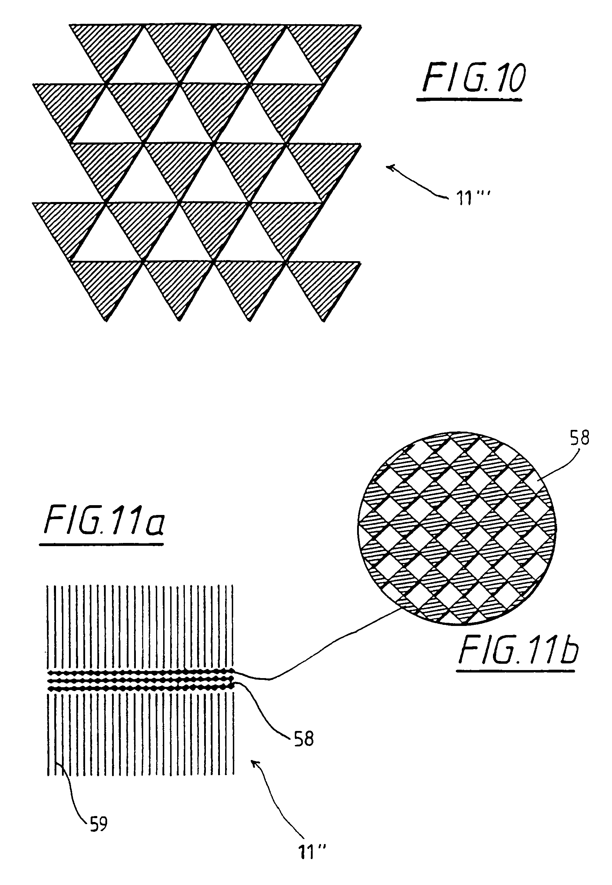

- Figur 1: 1b eine Ausschnittsvergrößerung von Figur 11 a;

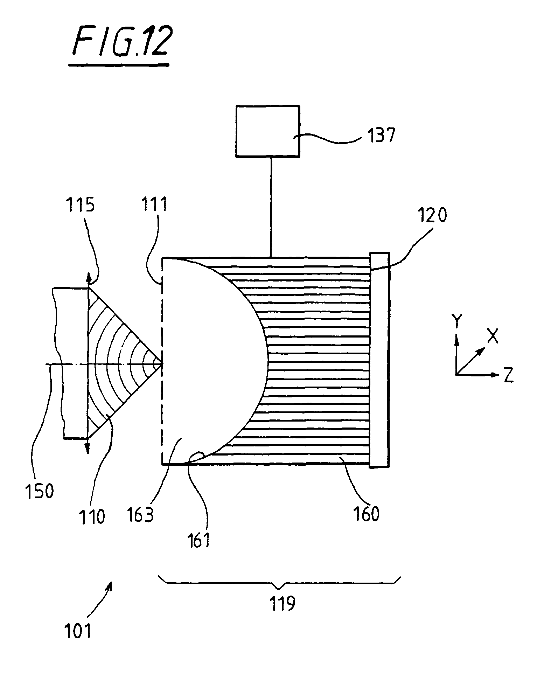

- Figur 12: eine als Beugungsgitter-Detektor-Einheit ausgebildete Vorrichtung zur Wellenfronterfassung;

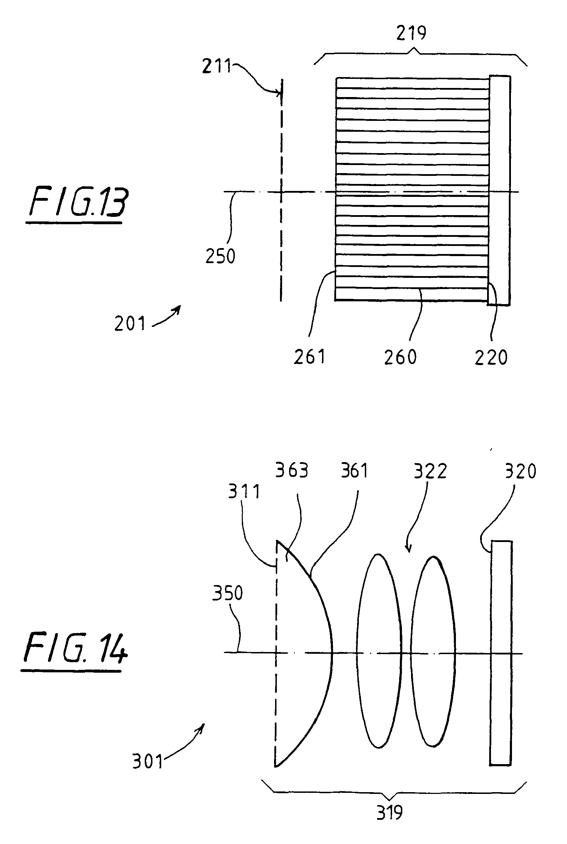

- Figur 13: eine als Beugungsgitter-Detektor-Einheit ausgebildete Ausgestaltung;
- Figur 14: eine als Beugungsgitter-Detektor-Einheit ausgebildete Ausgestaltung;

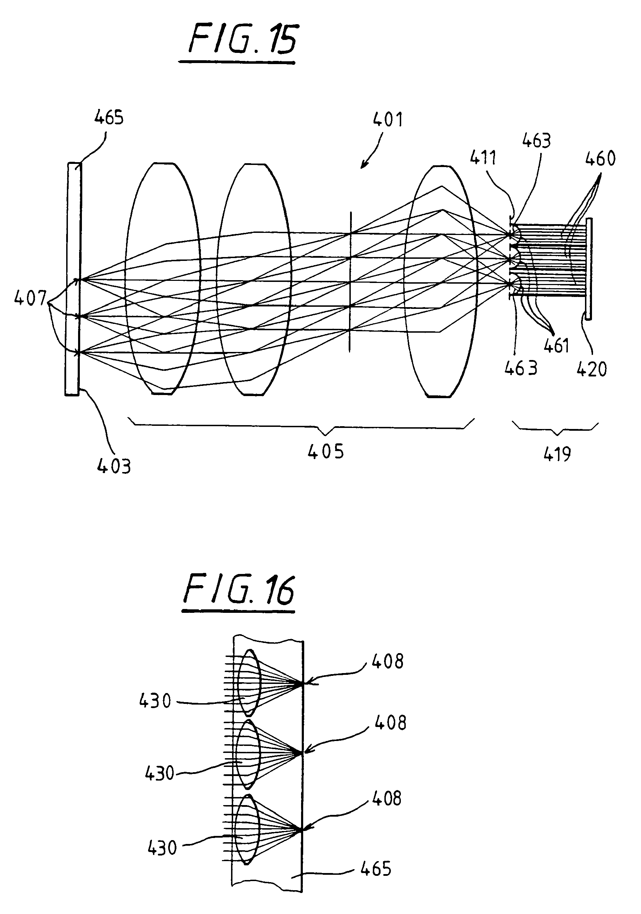

- Figur 15: eine Ausführungsform mit einer Mehrzahl paralleler Meßkanäle;
- Figur 16: eine vergrößerte Ausschnittsdarstellung des Wellenfrontmoduls der Ausführungsform von Figur 15;

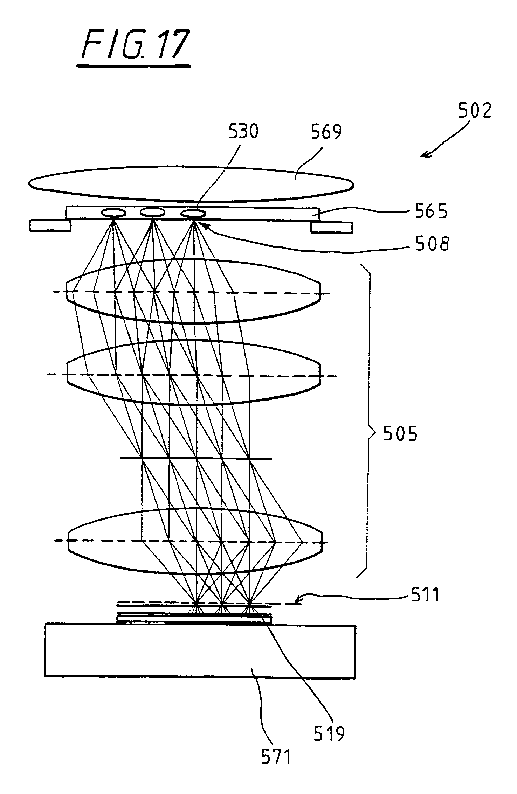

- Figur 17: eine Anordnung für die Mikrolithografie mit einer mehrkanaligen Vorrichtung zur Wellenfronterfassung; und

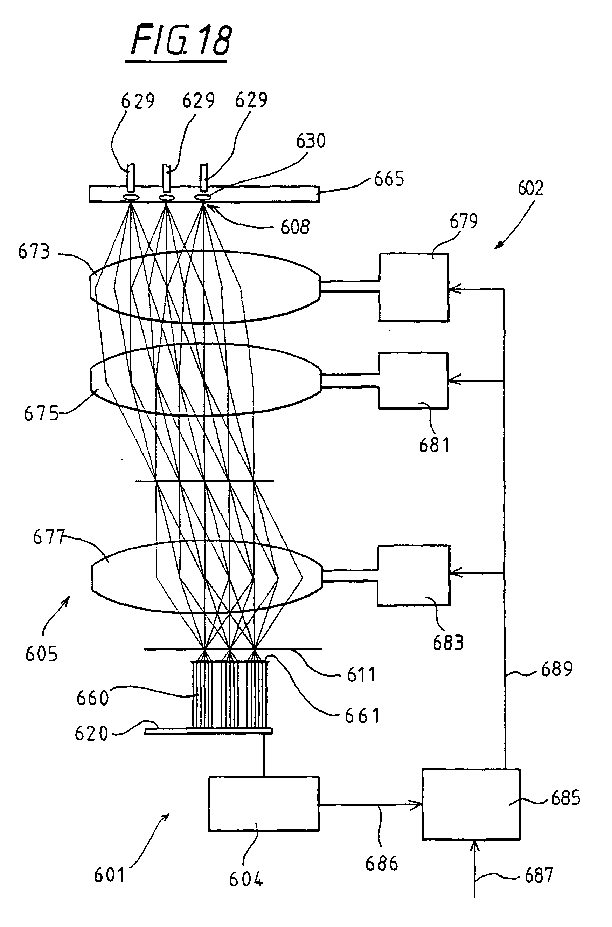

- Figur 18: eine Anordnung gemäß Figur 17 mit einem Aberrationsregelkreis.

In Figur 1 ist eine Vorrichtung 1 zur Wellenfronterfassung schematisch in einem Längsschnitt dargestellt. Dabei erzeugt eine in einer Objektebene 3 eines optischen Systems 5 angeordnete Wellenfrontquelle 7 eine Wellenfront. Die von der Wellenfrontquelle 7 ausgehenden, als Konturlinien schematisch dargestellten Wellenfronten 9 durchlaufen das optische System 5 und werden durch das optische System 5 zu ausgehenden Wellenfronten 10 umgeformt, welche dann auf ein Beugungsgitter 11 treffen.

Das optische System 5, dessen optische Achse 50 parallel zu einer Z-Richtung ist, umfaßt zwei als Doppelpfeile symbolisierte optische Elemente, z.B. Linsen, 13 und 15 und bildet die Wellenfrontquelle 7 auf das Beugungsgitter 11 ab, wobei das Beugungsgitter 11 in der zur Objektebene 3 konjugierten Bildebene liegt. Eine Aperturblende 17 des optischen Systems 5 ist in Figur 1 ebenfalls zu erkennen.

Dem Beugungsgitter 11 ist ein ortsauflösender Detektor 19 nachgeordnet. Der Detektor 19 umfaßt eine strahlungssensitive Sensorfläche 20, z. B. einen CCD-Chip, sowie ein zwischen dem Beugungsgitter 11 und der Sensorfläche 20 angeordnetes Abbildungssytem 22, welches das vom Beugungsgitter 11 erzeugte Interferogramm bzw. Scherogramm auf die Sensorfläche 20 abbildet. Das Abbildungssytem 22 weist ein Mikroskopobjektiv 21 und weitere optische Elemente 23 und 25 auf und bildet zusammen mit dem optischen Element 15 die Aperturblende 17 auf die Sensorfläche 20 ab, wie es durch den Pupillenstrahlengang 27 dargestellt ist. Das Abbildungssytem 22 ist sinuskorrigiert, wobei es die Qualität der Sinuskorrektur des Mikroskopobjektivs 21 ist, welche ausschlaggebend für die Konstanz der Scherdistanz über die vermessene Wellenfront ist.

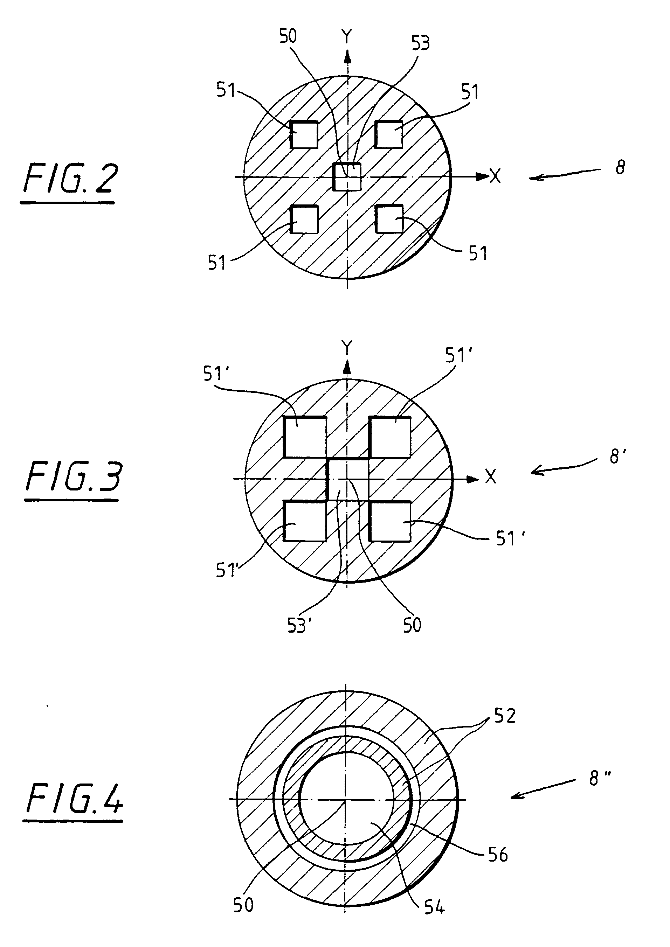

Die Wellenfrontquelle 7 umfaßt eine in Figur 2 detaillierter dargestellte Lochmaske 8, welche am Ausgang eines Lichtleiters 29 angebracht ist. Der Lichtleiter 29 ist zur Untersuchung des ganzen Bildfelds des optischen Systems 5 mittels eines Verschiebungsmoduls 31 parallel zur Objektebene 3 in X- und/oder Y-Richtung verschiebbar, was durch den Doppelpfeil 33 und die strichpunktierten Phantomdarstellungen 35 angedeutet ist.

Bei der Vorrichtung 1 wird von dem Verschiebungsmodul 31 zur Abtastung des Bildfelds des optischen Systems 5 simultan mit dem Lichtleiter 29 auch der Detektor 19 in X- und/oder Y-Richtung verschoben.

Das Beugungsgitter 11 kann von einem Translationsmodul 37 in der Bildebene des optischen Systems 5, d.h. in X- und/oder Y-Richtung, verschoben werden, um den Kontrast eines der orthogonalen Interferenzsysteme des Beugungsgitters 11 unterdrücken zu können.

Zwischen einer Strahlungsquelle 43 und der Wellenfrontquelle 7 ist ein erster Strahlteiler 45 zum Auskoppeln eines Teils der die Wellenfrontquelle versorgenden Strahlung angeordnet. Ein zwischen den optischen Elementen 23 und 25 in einem Fokuspunkt der Wellenfront angeordneter, zweiter Strahlteiler 47 lenkt den vom ersten Strahlteiler 45 ausgekoppelten Strahlungsanteil unter Umgehung von optischem System 5 und Beugungsgitter 11 zur Sensorfläche 20, wodurch die Konstanz der Strahlungsquelle 43 überwachbar ist. Dabei transportiert ein Referenzlichtleiter 49 den vom ersten Strahlteiler 45 ausgekoppelten Strahlungsanteil zum zweiten Strahlteiler 47.

Wie in Figur 2 zu erkennen ist, weist die Lochmaske 8 der Wellenfrontquelle 7 eine zentrisch zur optischen Achse 50 des optischen Systems 5 angeordnete, quadratische Öffnungen 53 und vier um die Öffnung 53 in Abstand und symmetrisch zur optischen Achse 50 herum angeordnete Öffnungen 51 auf.

In Figur 3 ist eine weitere Ausführungsform einer für die Wellenfrontquelle 7 geeigneten Lochmaske gezeigt. Diese Lochmaske 8' umfaßt eine gleichfalls zentrisch zur optischen Achse 50 des optischen Systems 5 angeordnete, quadratische Öffnungen 53' und vier an die Öffnung 53' angrenzende und symmetrisch zur optischen Achse 50 herum angeordnete Öffnungen 51'.

Je nach Anwendungsfall kann die Zahl der Öffnungen einer erfindungsgemäßen Lochmaske auch größer sein als in den Figuren 2 und 3.

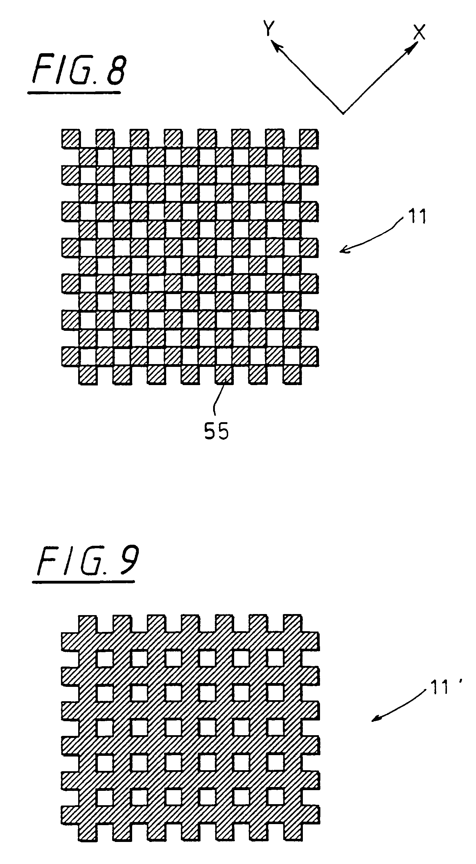

Diese zweidimensionale Strukturen der Wellenfiontquelle 7 sind derart auf die in den Figuren 8 und 9 dargestellten Beugungsgitter abgestimmt, daß zur Interferenz am Beugungsgitter nur bestimmte Beugungsordnungen beitragen.

In Figur 4 ist eine Lochmaske 8" mit rotationssymmetrischer Transmissionsverteilung gezeigt. Dabei sind eine zentrale Kreisfläche 54 sowie eine Ringfläche 56 transparent und komplementäre Ringflächen 52 opak.

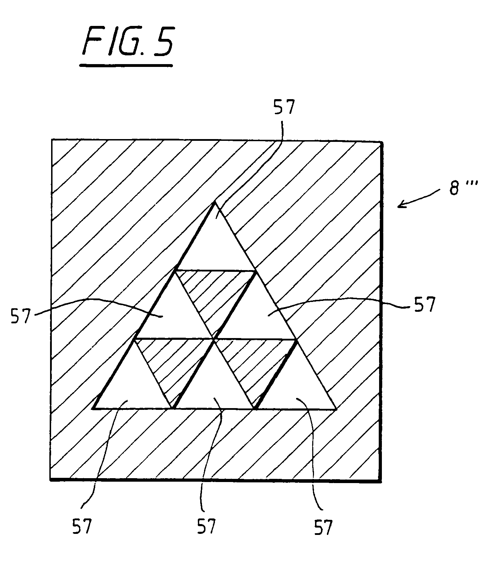

In Figur 5 ist eine Beleuchtungsmaske 8"' mit Öffnungen 57 dargestellt, welche als gleichseitige Dreiecke ausgebildet sind. Die Beleuchtungsmaske 8'" hat also eine dreizählige Symmetrie und wirkt im Hinblick auf die Auslöschung bestimmter Beugungsordnungen besonders vorteilhaft mit dem Beugungsgitter von Figur 10 zusammen.

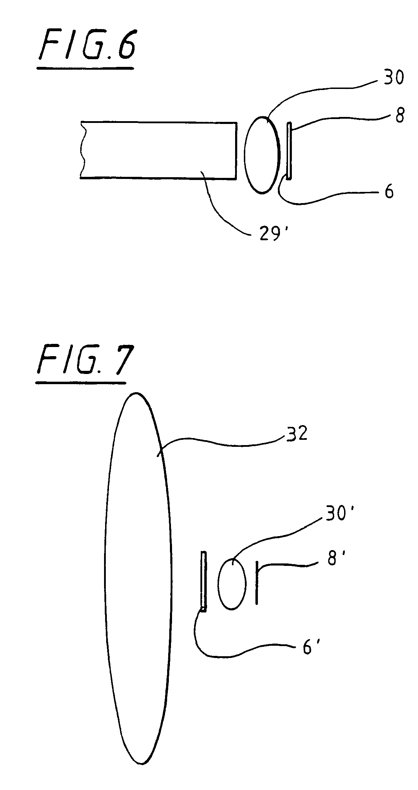

Die Figuren 6 und 7 zeigen alternative Ausführungsformen von Beleuchtungssystem-Beleuchtungsmasken-Anordnungen.

In Figur 6 ist eine Aufweitungs- oder Fokussierlinse 30 zwischen einer Lichtleitfaser 29' und einer auf einer Mattscheibe 6 angebrachten Lochmaske 8 angeordnet.

Über die Mattscheibe 6 kann die räumliche Kohärenz gesteuert werden, wobei zu beachten ist, daß die Beleuchtung der Lochmaske 8 idealerweise inkohärent ist, um durch die Lochmaskengeometrie die räumliche Kohärenzverteilung gezielt formen zu können.

Durch die Linse 30 kann die Beleuchtungsapertur an die Aperturblende 17 angepaßt werden. Dadurch kann die Aperturblende 17 vollständig ausgeleuchtet, d. h. eine Unterfüllung der Aperturblende 17 vermieden werden, auch wenn die numerische Apertur der Beleuchtungsfaser 29' und des optischen Systems einander nicht entsprechen.

In Figur 7 ist eine über eine Kondensorlinse 32 beleuchtete Lochmaske 8' mit dazwischen angeordneter Mattscheibe 6' und Aufweitungs- oder Fokussierlinse 30' gezeigt.

Das Beugungsgitter 11 ist in Figur 8 dargestellt. Das Beugungsgitter 11 umfaßt ein Schachbrettgitter 55, das die Interferenz, d.h. die laterale Scherung der Wellenfronten, bewirkt. Die in Figur 8 gezeichneten X- und Y-Richtungen entsprechen denjenigen der Figuren 1 bis 3 und sollen andeuten, daß das Schachbrettgitter 55 in der Vorrichtung 1 in Entsprechung zu den Öffnungen 51 und 53 bzw. 51' und 53' der Wellenfrontquellen 8 und 8' diagonal angeordnet ist.

Figur 9 zeigt eine weitere Ausführungsform eines für die Vorrichtung von Figur 1 geeigneten Beugungsgitters 11', welches ein als Kreuzgitter 11' ausgebildetes Amplitudengitter ist.

In Figur 10 ist eine weitere Ausführungsform eines für die Vorrichtung von Figur 1 geeigneten Beugungsgitters 11"' dargestellt, welches besonders vorteilhaft mit der Beleuchtungsmaske 8'" von Figur 5 zusammenwirkt. Das Beugungsgitters 11"' ist ein als Dreiecksgitter ausgebildetes Amplitudengitter und weist drei Beugungsrichtungen auf.

Ein weiteres vorteilhaftes Beugungsgitter 11" zeigen die Figuren 11a und 11b. Das Beugungsgitter 11" umfaßt ein Schachbrettgitter 58, das in Figur 11b vergrößert herausgezeichnet ist und die Interferenz, d.h. die laterale Scherung der Wellenfronten, bewirkt. In der Ebene des Schachbrettgitters 58 ist in einem für die Scherung der Wellenfront nicht benötigten Bereich ein mit dem Schachbrettgitter 58 verbundenes Moire-Liniengitter 59 angeordnet.

In Figur 12 ist eine weitere Vorrichtung 101 zur Wellenfronterfassung schematisch im Axiallängsschnitt dargestellt. Die den Elementen der Figuren 1 bis 9 entsprechenden Elemente in Figur 12 haben die gleichen Bezugszeichen vermehrt um die Zahl 100. Für eine Beschreibung dieser Elemente wird auf die Beschreibung zu den Figuren 1 bis 9 verwiesen.

Von einer Wellenfrontquelle ausgehende Wellenfronten durchlaufen ein optisches System, von dem lediglich das optische Element 115 dargestellt ist, und werden durch das optische System zu ausgehenden Wellenfronten 110 umgeformt, welche dann auf ein Beugungsgitter 111 treffen.

Das Beugungsgitter 111 ist mit einem ortsauflösenden Detektor 119 zu einer Beugungsgitter-Detektor-Einheit 111, 119 zusammengefaßt.

Dabei ist auf eine strahlungssensitive Sensorfläche 120 des Detektors 119 ein bilderhaltendes Lichtleiterfaserbündel 160 kontaktiert. Beugungsgitterseitig endet das Faserbündel 160 in einer sphärischen Fluoreszenzschicht 161, welche konzentrisch zum Schnittpunkt von optischer Achse 150 und Beugungsgitter 111 ist, wobei die optische Achse 150 wiederum parallel zur Z-Richtung ist.

In die konkave Fläche des Faserbündels 160 ist unter Ausbildung der Fluoreszenzschicht 161 eine transparente Halbkugel 163 mit einem fluoreszierenden Kitt gekittet, wobei die Halbkugel 163 auch dem Schutz der Fluoreszenzschicht 161 dient. Auf der Planseite der Halbkugel 163 ist das Beugungsgitter 111 angeordnet.

Aufgrund der Streuwirkung der Fluoreszenzschicht 161 in alle Richtungen kann durch die Fluoreszenzschicht 161 nicht nur eine Wellenlängenanpassung auf die spektrale Empfindlichkeit der Sensorfläche 120 erfolgen, sondern auch die Einkopplung der gebeugten Strahlung in die einzelnen Lichtleiterfasern verbessert werden. Falls eine Frequenz- bzw. Wellenlängenwandlung nicht erforderlich sein sollte, kann anstelle der Fluoreszenzschicht 161 eine streuende Sekundärstrahlerfläche auch durch Mattierung der konkaven Fläche des Faserbündels 160 erzielt werden.

Das Beugungsgitter 111 ist als Schachbrettgitter oder Kreuzgitter ausgebildet, d.h. es weist jeweils eine beugende periodische Struktur für die X-Richtung und für die dazu orthogonale Y-Richtung auf. Dadurch können aus einem einzigen, von dem ortsauflösenden Detektor 119 aufgenommenen Interferogramm Phasengradienten in mehr als einer Richtung bestimmt werden. Im Hinblick auf die Auswertung des Interferogramms ist dem Beugungsgitter 111 ein Translationsmodul 137 zur Verschiebung der Beugungsgitter-Detektor-Einheit 111, 119 und damit des Beugungsgitters 111 in jeweils der X- bzw. Y-Richtungen zugeordnet. Damit kann durch eine Bewegung des Beugungsgitters um ganzzahlige Vielfache der jeweiligen Gitterperiode während der Integrationszeit der strahlungssensitiven Sensorfläche 120 der Kontrast eines der orthogonalen Interferenzsysteme des Beugungsgitters 111 unterdrückt werden.

In Figur 13 ist eine weitere Beugungsgitter-Detektor-Einheit zu erkennen. Die den Elementen von Figur 12 entsprechenden Elemente in Figur 13 haben die gleichen Bezugszeichen wie in Figur 12 vermehrt um die Zahl 100. Für eine Beschreibung dieser Elemente wird auf die Beschreibung zu Figur 12 bzw. zu den Figuren 1 bis 9 verwiesen.

Bei der Beugungsgitter-Detektor-Einheit 201 von Figur 13 wird das Interferogramm von der Sekundärstrahlerfläche 261 auf den Bildsensor 220 über ein direkt mit der Sekundärstrahlerfläche 261 und dem Bildsensor 220 kontaktiertes, als Faserplatte ausgebildetes Lichtleiterfaserbündel 260 abgebildet. In diesem Beispiel kann das Beugungsgitter 211 getrennt vom Detektor 219 bewegt werden, z. B. für die erwähnten Verschiebung in einer der Periodizitätsrichtungen des Beugungsgitters 211 orthogonal zur optischen Achse 250. Daneben kann zur Einstellung der Austrittspupillengröße auf der Sensorfläche 220 das Beugungsgitter 211 auch parallel zur optischen Achse 250 verschoben werden.

In Figur 14 ist eine Beugungsgitter-Detektor-Einheit zu erkennen, bei der das Beugungsgitter und die Sekundärstrahlerfläche auf einem gemeinsamen Beugungsgitterträger angeordnet sind. Die den Elementen von Figur 12 entsprechenden Elemente in Figur 14 haben die gleichen Bezugszeichen vermehrt um die Zahl 200. Für eine Beschreibung dieser Elemente wird auf die Beschreibung zu Figur 12 bzw. zu den Figuren 1 bis 9 verwiesen.

Die Ausgestaltung 301 von Figur 14 weist ein telezentriertes optisches Abbildungssystem 322 auf, welches das Interferogramm von der auf der beugungsgitterfernen Seite des Beugungsgitterträgers 363 liegenden, zum Beugungsgitter 111 hin gekrümmten Sekundärstrahlerfläche 361 auf die strahlungssensitiven Sensorfläche 320 abbildet.

Eine ebene Sekundärstrahlerfläche könnte bei Verzicht auf das Abbildungssystem 322 der auch unmittelbar benachbart zur Sensorfläche angeordnet sein. Der Beugungsgitterträger könnte dadurch zugleich als Deckglas für die Sensorfläche 320 dienen.

In den Figuren 15 und 16 ist eine weitere Ausführungsform einer erfindungsgemäßen Vorrichtung zur Wellenfronterfassung dargestellt. Die den Elementen der Figuren 1 bis 9 bzw. der Figur 12 entsprechenden Elemente in den Figuren 15 und 16 tragen die gleichen Bezugszeichen wie in den Figuren 1 bis 9 bzw. in Figur 12 vermehrt um die Zahl 400 bzw. 300. Für eine Beschreibung dieser Elemente wird auf die Beschreibung zu den Figuren 1 bis 9 bzw. zu Figur 12 verwiesen.

Die Vorrichtung 401 umfaßt ein in Figur 16 ausschnittsweise im Detail dargestelltes Wellenfrontmodul 465 und eine Mehrzahl sphärischer Sekundärstrahlerflächen 461 mit diesen jeweils zugeordneten Lichtleiterfaserbündeln 460.

Das in Figur 16 ausschnittsweise gezeigte Wellenfrontmodul 407 umfaßt eine in der Objektebene des optischen Systems 405 ausgedehnte, zwei-dimensionale, z. B. hexagonale Anordnung von Fokussierlinsen 467 und Lochmasken 408, wobei jeweils eine Fokussierlinse 467 in Richtung auf das Beugungsgitter 411 zu einfallendes Beleuchtungslicht auf die zugeordnete Lochmaske 408 konzentriert.

Durch die Vorrichtung 40I zur Wellenfronterfassung können also die Wellenfronten im gesamten Bildfeld des optischen Systems 405 parallel für eine große Zahl von Feldpunkten erfaßt werden, was in Figur 15 anhand dreier, von den Wellenfrontquellen 407 ausgehender Strahlengänge angedeutet ist. Aufgrund der Erfindung kann damit das optische System 405 parallel, d.h. gleichzeitig, für eine Mehrzahl von Feldpunkten hinsichtlich seiner Abbildungseigenschaften vermessen werden.

Die Vorrichtung 405 ist damit eine mehrkanalige Vorrichtung zur Wellenfronterfassung, während die Vorrichtungen der Figuren 1 bis 14 in diesem Sinne einkanalig sind. Für die Vorrichtung 401 ist aber auch die Beugungsgitter-Detektor-Einheit von Figur 13 geeignet.

In Figur 17 ist eine Anordnung 502 für die Mikrolithografie, in die eine mehrkanalige erfindungsgemäße Vorrichtung zur Wellenfronterfassung integriert ist, schematisch dargestellt. Die den Elementen der Figur 15 entsprechenden Elemente in Figur 17 tragen die gleichen Bezugszeichen wie in Figur 15 vermehrt um die Zahl 100. Für eine Beschreibung dieser Elemente wird auf die Beschreibung zu Figur 15 verwiesen.

Die Mikrolithografieanordnung 502 ist insbesondere ein Stepper oder Scanner und umfaßt ein Mikrolithografie-Projektionsobjektiv 505, in dessen Objektebene im Austausch mit einem Reticle ein Wellenfrontmodul 565 eingeschoben oder eingeschwenkt werden kann. Über eine Beleuchtungsfeldlinse 569 wird das Wellenfrontmodul 565 mit Beleuchtungsstrahlung versorgt. Anstelle eines Wafers liegt, betriebsmäßig mit einem Wafer austauschbar, auf einer Waferstage 571 eine Beugungsgitter-Detektor-Einheit 511, 519 von dem in Figur 13 gezeigten Typ, wobei das Beugungsgitter 511 in der Bildebene des Projektionsobjektivs 505 angeordnet ist. Die im vorhergehenden erwähnte Verschiebung des Beugungsgitters 511 kann dabei mittels der ohnehin orthogonal zur optischen Achse des Projektionsobjektivs 505 bewegbaren Waferstage 571 erfolgen, wobei die gesamte Beugungsgitter-Detektor-Einheit 511, 519 bewegt wird. Da die Größenordnung der erforderlichen Verschiebungsstrecke typischerweise 10 µm ist, wird die durch diese Verschiebung verursachte Verlagerung der Austrittspupille auf der Sensorfläche vernachlässigbar klein.

Als Beugungsgitter-Detektor-Einheit kann für einen Stepper/Scanner zur Mikrolithografie vorzugsweise auch die in Figur 15 dargestellte Beugungsgitter-Detektor-Einheit mit bereichsweise sphärischem Detektor eingesetzt werden.

Mit dem Stepper/Scanner 502 zur Mikrolithografie kann aufgrund der Mehrkanaligkeit von Wellenfrontmodul 565 und Beugungsgitter-Detektor-Einheit 511, 519 z. B. die Verzeichnung des Projektionsobjektivs 505 gemessen werden. Da die Phasenbeziehungen unter den einzelnen Meßkanälen aufgrund der kompakten, zu einer Baueinheit zusammengefaßten Beugungsgitter-Detektor-Einheit fixiert und bekannt sind, können nämlich durch relative Phasenmessungen die relativen Wellenfrontverkippungen und damit die Verzeichnung bestimmt werden.

In Figur 18 ist eine Anordnung 602 für die Mikrolithografie mit einem Aberrationsregelkreis schematisch im Axiallängsschnitt dargestellt. Die den Elementen der Figur 17 entsprechenden Elemente in Figur 18 haben die gleichen Bezugszeichen vermehrt um die Zahl 100. Für eine Beschreibung dieser Elemente wird auf die Beschreibung zu Figur 17 bzw. zu den Figuren 1 bis 16 verwiesen.

Im Unterschied zum Stepper/Scanner 502 weist die Anordnung von Figur 18 als Beleuchtungssystem eine Mehrzahl von jeweils einer Lochmaske 608 zugeordnete Beleuchtungslichtleitfasern 629 auf. D.h. diese Beleuchtungsanordnung entspricht einem zweidimensionalen Array der in Figur 6 gezeigten Anordnung.

Bei dieser Matrixanordnung von Beleuchtungsfasem ist die optische Achse der Beleuchtung fest zur Hauptstrahlrichtung ausgerichtet und somit eine homogene Ausleuchtung der Aperturblende von jedem Objektfeldpunkt möglich.

Das Projektionsobjektiv 605 der als Stepper oder Scanner ausgebildeten Mikrolithografieanordnung 602 umfaßt als optische Elemente beispielhaft drei Linsen 673, 675 und 677. Den Linsen 673, 675 und 677 ist jeweils ein Wirkelement 679, 681 und zugeordnet, mit dem die Abbildungseigenschaften der entsprechenden Linse und damit des Projektionsobjektivs 605 steuerbar sind. Die Wirkelemente können z. B. Stellglieder, mit denen die zugeordnete Linse verschoben oder gedreht werden kann, oder Aktuatoren sein, mit denen die zugeordnete Linse gezielt verformt oder mechanischer Spannung ausgesetzt werden kann.

Eine Vorrichtung 601 zur Wellenfronterfassung umfaßt eine Auswerteeinheit 604, welche aus den von einer Sensorfläche 620 aufgenommenen Interferogrammen die momentane, für die Abbildungseigenschaften des Projektionsobjektivs 605 charakteristische Wellenfronttopographie bestimmt.

Von der Auswerteeinheit 604 wird ein der erfaßten momentanen Wellenfront entsprechendes Signal 686 an eine Vergleichseinrichtung 685 übergeben. Die Vergleichseinrichtung 685 vergleicht das Signal 686 mit einem den gewünschten Abbildungseigenschaften des Projektionsobjektivs 605 entsprechenden Sollwertsignal 687. Von dem Ergebnis des Vergleichs ausgehend werden Wirksignale 689 an die Wirkelemente 679, 681 und 683 gegeben, welche dadurch in einer die Aberrationen des Projektionsobjektivs 605 verkleinernden Weise auf die optischen Elemente 673, 675 und 677 einwirken.

Im Sinne eines Regelkreises, d.h. eines geschlossenen Kreises, werden diese Schritte solange wiederholt bis das Signal 686 dem Signal 687 entspricht, d.h. das Projektionsobjektiv 605 die gewünschten Abbildungseigenschaften aufweist.

Es ist aber auch möglich, die Anordnung 602 im Sinne einer Aberrationssteuerung, d.h. eines offenen Kreises, unter Verzicht auf Rückkopplungsschleifen zu betreiben.

Dafür ist es vorteilhaft, daß die Vorrichtung 601 die Wellenfronten im gesamten Bildfeld des Projektionsobjektivs 605 parallel für eine große Zahl von Feldpunkten erfassen kann. Daraus kann die Feldverteilung der Aberrationen berechnet werden. Aus dieser Feldverteilung der Aberrationen werden die von den Wirkelementen beeinflußbaren Aberrationskomponenten bestimmt und mit geeigneten Verfahren, z. B. auf optischen Berechnungen zum Projektionsobjektiv beruhenden Variationstabellen, werden dann die Stellgrößen für die Wirkelemente berechnet.

## Patentansprüche

1. Vorrichtung (1) zur Wellenfronterfassung mit einer Wellenfrontquelle (7) zur Erzeugung einer Wellenfront (9), einem der Wellenfrontquelle (7) nachgeordneten Beugungsgitter (11) und einem dem Beugungsgitter (11) nachgeordneten ortsauflösenden Detektor (19), **dadurch gekennzeichnet, dass** die Wellenfrontquelle (7) zur Erzeugung einer zum Durchlaufen eines zu vermessenden optischen Systems vorgesehenen Wellenfront eingerichtet ist und eine zweidimensionale Struktur aufweist.

2. Vorrichtung (1) nach Anspruch 1, wobei die Wellenfrontquelle (7) eine Beleuchtungsmaske (8; 8'; 8") mit örtlich variierender Transmission umfasst.

3. Vorrichtung (1) nach Anspruch 2, wobei die Beleuchtungsmaske (8") eine rotationssymmetrische Transmissionsverteilung aufweist.

4. Vorrichtung (1) nach einem der Ansprüche 1 bis 3, wobei die Wellenfrontquelle (7) eine Lochmaske (8 ;8' ; 8") umfasst.

5. Vorrichtung (1) nach Anspruch 4, wobei die Lochmaske (8 ; 8') eine Mehrzahl periodisch angeordneter Öffnungen (51, 53; 51', 53') aufweist.

6. Vorrichtung (1) nach Anspruch 5, wobei die Lochmaske (8; 8') eine Mehrzahl in vierzähliger Symmetrie angeordneter Öffnungen (51, 53 ; 51', 53') aufweist.

7. Vorrichtung (1) nach Anspruch 5, wobei die Lochmaske (8"') eine Mehrzahl in dreizähliger Symmetrie angeordneter Öffnungen (57) aufweist.

8. Vorrichtung (1) nach einem der Ansprüche 1 bis 7 mit einem Beleuchtungssystem, wobei die Beleuchtungsmaske (8; 8'; 8") zwischen dem Beleuchtungssystem und dem Beugungsgitter (11) angeordnet ist und zwischen dem Beleuchtungssystem und der Beleuchtungsmaske (8; 8'; 8") eine streuende Fläche (6; 6') angeordnet ist.

9. Vorrichtung (1) nach Anspruch 8, wobei das Beleuchtungssystem einen Lichtleiter (29; 29') umfasst.

10. Vorrichtung (1) nach Anspruch 9, wobei der Lichtleiter (29; 29') ein Multimode Lichtleiter ist.

11. Vorrichtung (1) nach Anspruch 9 oder 10, wobei die Beleuchtungsmaske (8; 8'; 8") mit dem Lichtleiter (29) verbunden ist.

12. Vorrichtung (1) nach einem der Ansprüche 8 bis 10, wobei der Beleuchtungsmaske (8 ; 8' ; 8") eine Optik (30; 30'; 430; 530; 630) zugeordnet ist, welche einfallendes Beleuchtungslicht zur Beleuchtungsmaske (8; 8'; 8" ; 408; 508; 608) hin konzentriert.

13. Vorrichtung (1) nach einem der Ansprüche 1 bis 12, wobei das Beugungsgitter (11) in Abhängigkeit von der Struktur der Wellenfrontquelle (7) derart ausgebildet ist, dass zur Interferenz am Beugungsgitter (11) nur bestimmte Beugungsordnungen beitragen.

14. Vorrichtung (1) nach einem der Ansprüche1 bis 13, wobei das Beugungsgitter (11) in unterschiedlichen Periodizitätsrichtungen jeweils eine beugende periodische Struktur aufweist.

15. Vorrichtung (1) nach Anspruch 14, wobei das Beugungsgitter (11) zwei zueinander orthogonale Periodizitätsrichtungen aufweist.

16. Vorrichtung (1) nach Anspruch 15, wobei das Beugungsgitter ein Kreuzgitter (11') ist.

17. Vorrichtung (1) nach Anspruch 15, wobei das Beugungsgitter (11) ein Schachbrettgitter (55) ist.

18. Vorrichtung (1) nach Anspruch 14, wobei das Beugungsgitter (11"') drei jeweils paarweise einen Winkel von 120° einschliessende Periodizitätsrichtungen aufweist.

19. Vorrichtung (1) nach Anspruch 18, wobei das Beugungsgitter ein Dreiecksgitter (11 "') ist.

20. Vorrichtung (1) nach einem der Ansprüche 1 bis 19, wobei das Beugungsgitter ein Gitter mit örtlich stetig variierender Transmission ist.

21. Vorrichtung (1) nach Anspruch 20, wobei das Beugungsgitter ein Sinusgitter ist.

22. Vorrichtung (1) nach einem der Ansprüche 1 bis 21, wobei das Beugungsgitter (11) ein Phasengitter ist.

23. Vorrichtung (1) nach einem der Ansprüche 1 bis 22, wobei das Beugungsgitter (11 ") ein in unterschiedlichen Periodizitätsrichtungen jeweils eine beugende periodische Struktur aufweisendes Gitter (58) und ein zu diesem koplanares Liniengitter (59) umfasst.

24. Vorrichtung (1) nach einem der Ansprüche 1 bis 23, wobei zwischen der Wellenfrontquelle (7) und dem Beugungsgitter (11) ein die Wellenfront (9) umformendes optisches System (5) angeordnet ist und wobei die Wellenfrontquelle (7) in einer Objektebene (3) des optischen Systems (5) und das Beugungsgitter (11) in einer zur Objektebene (3) konjugierten Bildebene des optischen Systems (5) liegt.

25. Vorrichtung (1) nach Anspruch 12 und einem der Ansprüche 1 bis 24, wobei dem Beugungsgitter (11) ein Translationsmodul (37) zur Verschiebung des Beugungsgitters (11) in den unterschiedlichen Periodizitätsrichtungen zugeordnet ist.

26. Vorrichtung (1) nach einem der Ansprüche 1 bis 25, wobei der Wellenfrontquelle (7) ein Verschiebungsmodul (31) zugeordnet ist, welches die Wellenfrontquelle (7) in der Objektebene (3) verschiebt.

27. Vorrichtung (1) nach Anspruch 26, wobei das Verschiebungsmodul (31) bei einer Verschiebung der Wellenfrontquelle (7) in der Objektebene (3) auch den Detektor (19) parallel zur Bildebene verschiebt.

28. Vorrichtung (1 ; 301) nach einem der Ansprüche1 bis 27, wobei der Detektor (19 ; 319) eine strahlungssensitive Sensorfläche (20 ; 320) und ein zwischen dem Beugungsgitter (11 ; 311) und der Sensorfläche (20 ; 320) angeordnetes Abbildungssystem (22 ; 322) umfasst.

29. Vorrichtung (1; 301) nach Anspruch 28, wobei das Abbildungssystem (22; 322) im Hinblick auf die Abbesche Sinusbedingung korrigiert ist.

30. Vorrichtung (1 ; 301) nach Anspruch 28 oder 29, wobei das Abbildungssystem (22 ; 322) telezentrisch ist.

31. Vorrichtung (1) nach einem der Ansprüche1 bis 30, wobei zwischen einer Strahlungsquelle (43) und der Wellenfrontquelle (7) ein erster Strahlteiler (45) zum Auskoppeln eines Teils der die Wellenfrontquelle (7) versorgenden Strahlung angeordnet ist und ein zweiter, dem Beugungsgitter (11) nachgeordneter Strahlteiler (47) den vom ersten Strahlteiler (45) ausgekoppelten Strahlungsanteil zur Sensorfläche (20) lenkt.

32. Vorrichtung (1) nach Anspruch 31, wobei ein Referenzlichtleiter (49) den vom ersten Strahlteiler (45) ausgekoppelten Strahlungsanteil zum zweiten Strahlteiler (47) transportiert.

33. Vorrichtung (101 ;201 ;301 ;401) nach einem der Ansprüche 1 bis 32, wobei der Detektor (119; 219; 319; 419) eine Sekundärstrahlerfläche (161; 261; 361; 461) umfasst.

34. Vorrichtung (101 ; 201 ; 401) nach einem der Ansprüche 1 bis 33, wobei der Detektor eine Mehrzahl von Lichtleitern (160; 260; 460) umfasst.

35. Anordnung (502; 602) für die Mikrolithografie mit einem Projektionsobjektiv (505 ; 605) und mit einer Vorrichtung nach einem der Ansprüche 1 bis 34, wobei die Wellenfrontquelle (507; 607) betriebsmäßig in die/aus der Objektebene des Projektionsobjektivs (505; 605) bringbar/entfembar ist.

36. Anordnung (502; 602) für die Mikrolithografie mit einem Projektionsobjektiv (505 ; 605) und mit einer Vorrichtung nach einem der Ansprüche 1 bis 34, wobei das Beugungsgitter (511; 611) betriebsmäßig in die/aus der Bildebene des Projektionsobjektivs (505; 605) bringbar/entfembar ist.

37. Anordnung (602) für die Mikrolithografie nach Anspruch 35 oder 36, wobei das Projektionsobjektiv (605) mindestens ein optisches Element (673,675,677) umfasst und mindestens einem der optischen Elemente (673,675,677) des Projektionsobjektivs (605) ein Wirkelement (679,681,683) zugeordnet ist, mit dem die Abbildungseigenschaften des optischen Elements (673,675,677) veränderbar sind und welches über die Vorrichtung (601) zur Wellenfronterfassung steuerbar ist.

38. Anordnung (602) für die Mikrolithografie nach Anspruch 36, wobei eine Vergleichseinrichtung (685) von der Vorrichtung (601) zur Wellenfronterfassung abgegebene, der erfassten Wellenfront entsprechende Signale (686) mit einem Sollwert (687) vergleicht, welcher gewünschten Abbildungseigenschaften des Projektionsobjektivs (605) entspricht, und wobei die Vergleichseinrichtung (685) Signale (689) zur Steuerung des Wirkelements (679,681,683) abgibt.

## Claims

1. Device (1) for detecting wavefronts comprising a wavefront source (7) for generating a wavefront (9), a diffraction grating (11) disposed downstream of the wavefront source (7), and a spatially resolving detector (19) disposed downstream of the diffraction grating (11), **characterized in that** the wavefront source (7) is set up for generating a wavefront provided for passing through an optical system to be measured and has a two-dimensional structure.

2. Device (1) according to Claim 1, wherein the wavefront source (7) comprises an illumination mask (8; 8'; 8") with locally varying transmission.

3. Device (1) according to Claim 2, wherein the illumination mask (8") has a rotationally symmetrical transmission distribution.

4. Device (1) according to one of Claims 1 to 3, wherein the wavefront source (7) comprises a perforated mask (8; 8'; 8'').

5. Device (1) according to Claim 4, wherein the perforated mask (8; 8') has a plurality of openings (51, 53; 51', 53') arranged periodically.

6. Device (1) according to Claim 5, wherein the perforated mask (8; 8') has a plurality of openings (51, 53; 51', 53') arranged with four-fold symmetry.

7. Device (1) according to Claim 5, wherein the perforated mask (8"') has a plurality of openings (57) arranged with three-fold symmetry.

8. Device (1) according to one of Claims 1 to 7 comprising an illumination system, wherein the illumination mask (8; 8'; 8") is arranged between the illumination system and the diffraction grating (11) and a scattering surface (6; 6') is arranged between the illumination system and the illumination mask (8; 8'; 8'').

9. Device (1) according to Claim 8, wherein the illumination system comprises an optical waveguide (29; 29').

10. Device (1) according to Claim 9, wherein the optical waveguide (29; 29') is a multimode optical waveguide.

11. Device (1) according to Claim 9 or 10, wherein the illumination mask (8; 8'; 8") is connected to the optical waveguide (29).

12. Device (1) according to one of Claims 8 to 10, wherein the illumination mask (8; 8'; 8") is assigned an optic (30; 30'; 430; 530; 630) which concentrates incident illumination light towards the illumination mask (8; 8'; 8" ; 408; 508; 608).

13. Device (1) according to one of Claims 1 to 12, wherein the diffraction grating (11) is embodied in a manner dependent on the structure of the wavefront source (7) in such a way that only specific orders of diffraction contribute to the interference at the diffraction grating (11).

14. Device (1) according to one of Claims 1 to 13, wherein the diffraction grating (11) has in each case a diffracting periodic structure in different periodicity directions.

15. Device (1) according to Claim 14, wherein the diffraction grating (11) has two periodicity directions that are orthogonal to one another.

16. Device (1) according to Claim 15, wherein the diffraction grating is a cross grating (11').

17. Device (1) according to Claim 15, wherein the diffraction grating (11) is a checkerboard grating (55).

18. Device (1) according to Claim 14, wherein the diffraction grating (11"') has three periodicity directions which include an angle of 120° in each case in pairs.

19. Device (1) according to Claim 18, wherein the diffraction grating is a triangular grating (11''').

20. Device (1) according to one of Claims 1 to 19, wherein the diffraction grating is a grating having locally continuously varying transmission.

21. Device (1) according to Claim 20, wherein the diffraction grating is a sinusoidal grating.

22. Device (1) according to one of Claims 1 to 21, wherein the diffraction grating (11) is a phase grating.

23. Device (1) according to one of Claims 1 to 22, wherein the diffraction grating (11") comprises a grating (58) having in each case a diffracting periodic structure in different periodicity directions and a line grating (59) that is coplanar with respect to said grating (58).

24. Device (1) according to one of Claims 1 to 23, wherein an optical system (5) that converts the wavefront (9) is arranged between the wavefront source (7) and the diffraction grating (11), and wherein the wavefront source (7) lies in an object plane (3) of the optical system (5) and the diffraction grating (11) lies in an image plane of the optical system (5), said image plane being conjugate with respect to the object plane (3).

25. Device (1) according to Claim 12 and one of Claims 1 to 24, wherein the diffraction grating (11) is assigned a translation module (37) for displacing the diffraction grating (11) in the different periodicity directions.

26. Device (1) according to one of Claims 1 to 25, wherein the wavefront source (7) is assigned a displacement module (31) which displaces the wavefront source (7) in the object plane (3).

27. Device (1) according to Claim 26, wherein the displacement module (31) also displaces the detector (19) parallel to the image plane in the event of a displacement of the wavefront source (7) in the object plane (3).

28. Device (1; 301) according to one of Claims 1 to 27, wherein the detector (19; 319) comprises a radiation-sensitive sensor surface (20; 320) and an imaging system (22; 322) arranged between the diffraction grating (11; 311) and the sensor surface (20; 320).

29. Device (1; 301) according to Claim 28, wherein the imaging system (22; 322) is corrected with regard to the Abbe sine condition.

30. Device (1; 301) according to Claim 28 or 29, wherein the imaging system (22; 322) is telecentric.

31. Device (1) according to one of Claims 1 to 30, wherein a first beam splitter (45) for coupling out a part of the radiation supplying the wavefront source (7) is arranged between a radiation source (43) and the wavefront source (7), and a second beam splitter (47), which is disposed downstream of the diffraction grating (11), directs the radiation portion coupled out by the first beam splitter (45) to the sensor surface (20).

32. Device (1) according to Claim 31, wherein a reference optical waveguide (49) transports the radiation portion coupled out by the first beam splitter (45) to the second beam splitter (47).

33. Device (101; 201; 301; 401) according to one of Claims 1 to 32, wherein the detector (119; 219; 319; 419) comprises a secondary radiator surface (161; 261; 361; 461).

34. Device (101; 201; 401) according to one of Claims 1 to 33, wherein the detector comprises a plurality of optical waveguides (160; 260; 460).

35. Arrangement (502; 602) for microlithography comprising a projection objective (505; 605) and comprising a device according to one of Claims 1 to 34, wherein the wavefront source (507; 607) can be operationally introduced into/removed from the object plane of the projection objective (505; 605).

36. Arrangement (502; 602) for microlithography comprising a projection objective (505; 605) and comprising a device according to one of Claims 1 to 34, wherein the diffraction grating (511; 611) can be operationally introduced into/removed from the image plane of the projection objective (505; 605).

37. Arrangement (602) for microlithography according to Claim 35 or 36, wherein the projection objective (605) comprises at least one optical element (673, 675, 677) and at least one of the optical elements (673, 675, 677) of the projection objective (605) is assigned an operative element (679, 681, 683) by means of which the imaging properties of the optical element (673, 675, 677) can be altered and which can be controlled by means of the device (601) for detecting wavefronts.

38. Arrangement (602) for microlithography according to Claim 36, wherein a comparison unit (685) compares signals (686) which are output by the device (601) for detecting wavefronts and correspond to the detected wavefront with a desired value (687) corresponding to desired imaging properties of the projection objective (605), and wherein the comparison unit (685) outputs signals (689) for controlling the operative element (679, 681, 683).

## Revendications

1. Dispositif (1) pour mesurer un front d'onde, comprenant une source de front d'onde (7) pour produire un front d'onde (9), un réseau de diffraction (11) placé après la source de front d'onde (7) et un détecteur (19) à résolution spatiale placé après le réseau de diffraction (11), **caractérisé en ce que** la source de front d'onde (7) est prévue pour produire un front d'onde prévu pour traverser un système optique à mesurer et présente une structure bidimensionnelle.

2. Dispositif (1) selon la revendication 1, dans lequel la source de front d'onde (7) comprend un masque d'éclairage (8 ; 8' ; 8") avec une transmission variable spatialement.

3. Dispositif (1) selon la revendication 2, dans lequel le masque d'éclairage (8") présente une distribution de transmission à symétrie de révolution.

4. Dispositif (1) selon l'une quelconque des revendications 1 à 3, dans lequel la source de front d'onde (7) comprend un masque perforé (8 ; 8' ; 8").

5. Dispositif (1) selon la revendication 4, dans lequel le masque perforé (8 ; 8') présente une pluralité d'ouvertures (51, 53 ; 51', 53') disposées périodiquement.

6. Dispositif (1) selon la revendication 5, dans lequel le masque perforé (8 ; 8') présente une pluralité d'ouvertures (51, 53 ; 51', 53') disposées suivant une symétrie quadruple.

7. Dispositif (1) selon la revendication 5, dans lequel le masque perforé (8") présente une pluralité d'ouvertures (57) disposées suivant une symétrie triple.

8. Dispositif (1) selon l'une quelconque des revendications 1 à 7, comprenant un système d'éclairage, dans lequel le masque d'éclairage (8 ; 8' ; 8") est disposé entre le système d'éclairage et le réseau de diffraction (11) et une surface de dispersion (6 ; 6') est disposée entre le système d'éclairage et le masque d'éclairage (8 ; 8' ; 8").

9. Dispositif (1) selon la revendication 8, dans lequel le système d'éclairage comprend un guide de lumière (29 ; 29').

10. Dispositif (1) selon la revendication 9, dans lequel le guide de lumière (29 ; 29') est un guide de lumière multimode.

11. Dispositif (1) selon la revendication 9 ou 10, dans lequel le masque d'éclairage (8 ; 8' ; 8") est connecté au guide de lumière (29).

12. Dispositif (1) selon l'une quelconque des revendications 8 à 10, dans lequel on associe au masque d'éclairage (8 ; 8' ; 8") une optique (30 ; 30' ; 430 ; 530 ; 630) qui concentre la lumière d'éclairage incidente vers le masque d'éclairage (8 ; 8' ; 8" ; 408 ; 508 ; 608).

13. Dispositif (1) selon l'une quelconque des revendications 1 à 12, dans lequel le réseau de diffraction (11) est réalisé en fonction de la structure de la source de front d'onde (7) de telle sorte que seulement des ordres de diffraction déterminés contribuent à l'interférence sur le réseau de diffraction (11).

14. Dispositif (1) selon l'une quelconque des revendications 1 à 13, dans lequel le réseau de diffraction (11) présente à chaque fois une structure périodique de diffraction dans des sens de périodicité différents.

15. Dispositif (1) selon la revendication 14, dans lequel le réseau de diffraction (11) présente deux sens de périodicité perpendiculaires.

16. Dispositif (1) selon la revendication 15, dans lequel le réseau de diffraction est un réseau en croix (11').

17. Dispositif (1) selon la revendication 15, dans lequel le réseau de diffraction (11) est un réseau en échiquier (55).

18. Dispositif (1) selon la revendication 14, dans lequel le réseau de diffraction (11"') présente trois sens de périodicité formant à chaque fois par paire un angle de 120°.

19. Dispositif (1) selon la revendication 18, dans lequel le réseau de diffraction est un réseau triangulaire (11"').

20. Dispositif (1) selon l'une quelconque des revendications 1 à 19, dans lequel le réseau de diffraction est un réseau à transmission à variation spatiale continue.

21. Dispositif (1) selon la revendication 20, dans lequel le réseau de diffraction est un réseau sinusoïdal.

22. Dispositif (1) selon l'une quelconque des revendications 1 à 21, dans lequel le réseau de diffraction (11) est un réseau de phase.

23. Dispositif (1) selon l'une quelconque des revendications 1 à 22, dans lequel le réseau de diffraction (11") comprend un réseau (58) présentant dans des sens de périodicité différents à chaque fois une structure périodique de diffraction et un réseau linéaire (59) coplanaire à celui-ci.

24. Dispositif (1) selon l'une quelconque des revendications 1 à 23, dans lequel, entre la source de front d'onde (7) et le réseau de diffraction (11) est disposé un système optique (5) formant le front d'onde (9) et dans lequel la source de front d'onde (7) se situe dans un plan objet (3) du système optique (5) et le réseau de diffraction (11) se situe dans un plan image conjugué au plan objet (3) du système optique (5).

25. Dispositif (1) selon la revendication 12 et l'une quelconque des revendications 1 à 24, dans lequel on associe au réseau de diffraction (11) un module de translation (37) pour le déplacement du réseau de diffraction (11) dans les différents sens de périodicité.

26. Dispositif (1) selon l'une quelconque des revendications 1 à 25, dans lequel on associe à la source de front d'onde (7) un module de déplacement (31) qui déplace la source de front d'onde (7) dans le plan objet (3).

27. Dispositif (1) selon la revendication 26, dans lequel le module de déplacement (31) déplace aussi le détecteur (19) parallèlement au plan image dans le cas d'un déplacement de la source de front d'onde (7) dans le plan objet (3).

28. Dispositif (1 ; 301) selon l'une quelconque des revendications 1 à 27, dans lequel le détecteur (19 ; 319) comprend une surface de capteur (20 ; 320) sensible aux rayonnements et un système de reproduction (22 ; 322) disposé entre le réseau de diffraction (11 ; 311) et la surface de détecteur (20 ; 320).

29. Dispositif (1 ; 301) selon la revendication 28, dans lequel le système de reproduction (22 ; 322) est corrigé en fonction de la condition des sinus d'Abbe.

30. Dispositif (1 ; 301) selon l'une quelconque des revendications 28 ou 29, dans lequel le système de reproduction (22 ; 322) est télécentrique.

31. Dispositif (1) selon l'une quelconque des revendications 1 à 30, dans lequel un premier diviseur de faisceau (45) pour désaccoupler une partie du rayonnement alimentant la source de front d'onde (7) est disposé entre une source de rayonnement (43) et la source de front d'onde (7), et un deuxième diviseur de faisceau (47) placé après le réseau de diffraction (11) oriente la partie du rayonnement désaccouplée par le premier diviseur de faisceau (45) vers la surface de détecteur (20).

32. Dispositif (1) selon la revendication 31, dans lequel un guide de lumière de référence (49) transporte la partie du rayonnement désaccouplée par le premier diviseur de faisceau (45) jusqu'au deuxième diviseur de faisceau (47).

33. Dispositif (101 ; 201 ; 301 ; 401) selon l'une quelconque des revendications 1 à 32, dans lequel le détecteur (119 ; 219 ; 319 ; 419) comprend une surface d'émetteur de rayonnement secondaire (161 ; 261 ; 361 ; 461).

34. Dispositif (101 ; 201 ; 401) selon l'une quelconque des revendications 1 à 33, dans lequel le détecteur comprend une pluralité de guides de lumière (160 ; 260 ; 460).

35. Agencement (502 ; 602) pour la microlithographie, comprenant un objectif de projection (505 ; 605) et un dispositif selon l'une quelconque des revendications 1 à 34, dans lequel la source de front d'onde (507 ; 607) peut être introduite en fonction du mode de fonctionnement dans le plan objet de l'objectif de projection (505 ; 605), ou en être écartée.

36. Agencement (502 ; 602) pour la microlithographie, comprenant un objectif de projection (505 ; 605) et un dispositif selon l'une quelconque des revendications 1 à 34, dans lequel le réseau de diffraction (511 ; 611) peut être introduit en fonction du mode de fonctionnement dans le plan image de l'objectif de projection (505 ; 605), ou en être écarté.

37. Agencement (602) pour la microlithographie selon la revendication 35 ou 36, dans lequel l'objectif de projection (605) comprend au moins un élément optique (673, 675, 677) et un élément fonctionnel (679, 681, 683) est associé à au moins l'un des éléments optiques (673, 675, 677) de l'objectif de projection (605), avec lequel les propriétés de reproduction de l'élément optique (673, 675, 677) peuvent être modifiées et qui peut être commandé par le biais du dispositif (601) pour mesurer un front d'onde.

38. Agencement (602) pour la microlithographie selon la revendication 36, dans lequel un dispositif de comparaison (685) compare les signaux (686) émis par le dispositif (601) pour mesurer un front d'onde, correspondant au front d'onde mesuré, à une valeur de consigne (687) qui correspond aux propriétés de reproduction souhaitées de l'objectif de projection (605), et dans lequel le dispositif de comparaison (685) émet des signaux (689) pour la commande de l'élément fonctionnel (679, 681, 683).
